Europäisches Patentamt

(19) European Patent Office

Office européen des brevets

(11) EP 0 966 040 A1

(12) **EUROPEAN PATENT APPLICATION**

(43) Date of publication:
22.12.1999 Bulletin 1999/51

(51) Int. Cl.$^6$: **H01L 23/64**, H01L 21/762, H01L 21/3205

(21) Application number: 98304845.5

(22) Date of filing: 19.06.1998

(84) Designated Contracting States:
**AT BE CH CY DE DK ES FI FR GB GR IE IT LI LU MC NL PT SE**
Designated Extension States:
**AL LT LV MK RO SI**

(71) Applicant:
**INTERNATIONAL BUSINESS MACHINES CORPORATION**
**Armonk, NY 10504 (US)**

(72) Inventors:
• **Harame, David Louis**
**Mohegan Lake, New York 10547 (US)**
• **Stein, Kenneth Jay**
**Sandy Hook, Connecticut 06482 (US)**

(74) Representative:
**Litherland, David Peter**
**IBM United Kingdom Limited**
**Intellectual Property Department**
**Hursley Park**
**Winchester, Hampshire SO21 2JN (GB)**

(54) **Passive component above isolation trenches**

(57) An integrated circuit and method of forming is described incorporating a substrate, a plurality of trenches in the substrate, a layer of insulation and a passive component such as an inductor above. The invention overcomes the problem of passive components such as spiral inductors with low Q and low self resonance frequencies.

Fig. 1

## Description

This invention relates generally to integrated circuits and more particularly to integrated circuits in which passive components are fabricated above a semiconductor substrate.

RF and Microwave devices designed for analog and wireless applications have typically been manufactured using III-V gallium Arsenide (GaAs) materials due to the frequency range and transistor speed of operation.

As conventional silicon bipolar and CMOS technology continues to advance the state-of-the-art, and bipolar circuits in particular approach the operating frequencies of GaAs integrated circuits, circuit designers have taken advantage of the low cost, high yield and large wafer diameter silicon foundries found in mainstream fabricators to produce integrated circuits capable of matching performance of so called "III-V" components.

An essential component of an Analog/Mixed Signal circuit are the Passive elements. Passive elements, namely inductors and metal-insulator-metal (MIM) capacitors, are especially required in high frequency analog devices, as part of a tank circuit in voltage controlled oscillators (VCO).

One of the major differences between silicon 10 to 18 ohm-cm and III-V materials is silicon's relatively low substrate resistivity, which may be 1 to 3 orders of magnitude lower. While this low resistivity is required for functionality of the bipolar devices, the passive elements, particularly on-chip inductors, are degraded significantly in their Quality (Q) factor. For example, a series-resonant LC circuit, which will have a Q determined by the reactance of either the inductor or capacitor at the resonant frequency divided by the series resistance in the circuit which is expressed as Q=X/R where X is the reactance of either the inductor ($2\pi fL$) or capacitor ($1/2\pi fC$) and R is the resistance. These inductors suffer from capacitive loss to the substrate, greatly reducing their inductance and Q factor at the higher frequency ranges. Simulation (SPICE) models for inductors on silicon substrates reference the "inductor to substrate capacitance" as a factor which has a deleterious effect on the Quality (Q) value.

In silicon and/or silicon germanium technology, a relatively low resistivity substrate (compared to III-V materials) is employed to reduce crosstalk between devices and noise. On-chip inductors fabricated on low resistivity wafers typically have poor Q factors, forcing chip manufacturers to provide off-chip and/or exotic on-chip solutions which add additional manufacturing cost and complexity.

In accordance with the invention, an integrated circuit and method for making is described comprising a semiconductor substrate, a plurality of spaced apart trenches substantially parallel to one another formed in the semiconductor substrate, the trenches having sidewalls preferably coated with an insulator, the trenches filled with a material to provide a continuous top surface across the plurality of trenches, an insulator layer formed above the plurality of spaced apart trenches, and a passive component such as an inductor formed above the plurality of spaced apart trenches whereby the plurality of spaced apart trenches below the passive component form a high resistance region with respect to the substrate.

The invention provides a simple technique, in the form of trenches, to reduce the capacitive loss to the substrate thereby further enhancing the Q value of on-chip inductors.

In the embodiment described below, the invention further provides replacing the intrinsic silicon semiconductor substrate area, over which the electronic device is fabricated, with a highly resistive area formed by oxide lined deep trenches filled with intrinsic polysilicon thereby reducing the capacitive loss to the substrate of the electronic device. If the electronic device is an inductor, this technique increases the peak Q factor of the inductor.

The embodiment also describes a method of fabricating an array of deep trenches in a substrate, over which one or more high Q inductors are fabricated.

Viewed from one aspect, the invention further provides a method of isolating bipolar devices by providing deep trenches which are etched into the semiconductor substrate to provide a physical barrier to electronic crosstalk between circuits.

In the embodiment described below, the invention further provides trenches which are etched into the semiconductor substrate, then lined with deposited oxide by low pressure chemical vapor deposition (LPCVD), and filled with LPCVD intrinsic poly-silicon. Further, the invention further allows for replacing as much of the intrinsic silicon substrate as possible with oxide/polysilicon filled deep trenches, the capacitive loss to the substrate is incrementally reduced, essentially for free. An incremental, yet measurable increase in the Q factor is realized.

It is further desirable to maximize the total area of deep trenches under an electronic device such as an inductor, while staying with-in ground rules for the design. The proper trench width, and spacing between trenches must be maintained in order not to impact neighboring electronic device elements.

In one embodiment, the invention further provides an area of "cross-hatched" trenches, covering the entire area underneath an electronic device such as an inductor to maximize the deep trench substitution of the semiconductor substrate which may be silicon.

The spiral inductor with which the trenches may be used may be comprised of single or multi-level metal layers typically found in CMOS integrated circuits.

A detailed description of the invention will now be provided, by way of example only, with reference to the accompanying drawings in which:

Fig. 1 is cross section view (not to scale) of one embodiment of the invention;

Fig. 2 is an enlarged view of a portion of Fig. 1 showing isolation trench 30;

Fig 3. is a top view of the embodiment in Fig. 1;

Fig. 4 is a top view of an alternate embodiment of Fig. 1 prior to depositing vias and metal layers 37-39 over cross hatched isolation trenches; and

Fig. 5 is a graph showing the inductance of a spiral inductor built in accordance with Fig. 1 as a function of frequency. The inductance of a spiral inductor built without isolation trenches below is also shown for reference, as fabricated on the same silicon wafer. The Q factor of the inductors as a function of frequency is also shown.

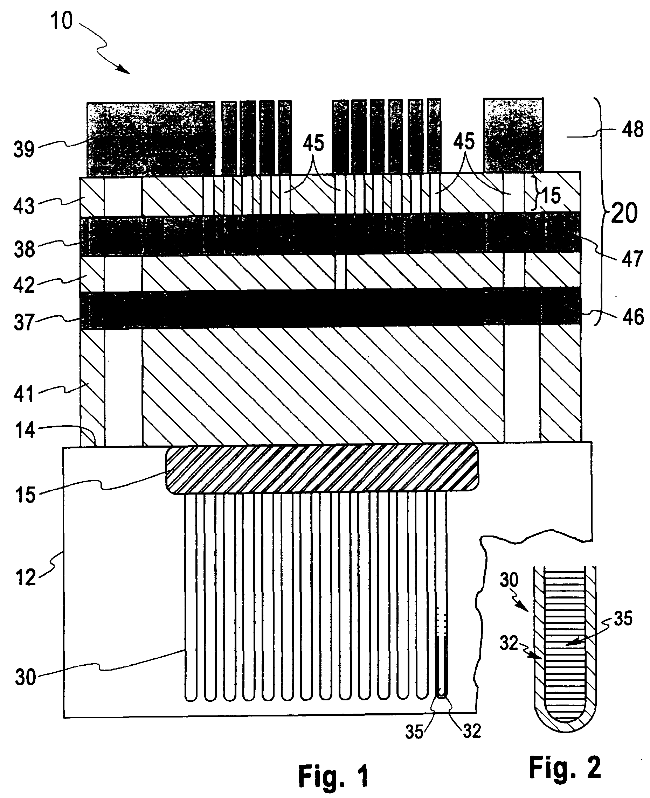

Referring now to the drawing, Fig. 1 shows a cross section view of an integrated circuit 10. A substrate 12 which may be a semiconductor such as Si or SiGe is shown upon which an inductor 20 is formed. In substrate 12, isolation trenches 30 have been fabricated. Isolation trenches 30 may be etched into substrate 12 for device isolation or capacitor charge storage. The depth of the isolation trench 30 can be variable and is determined by the design ground rules and device operation guidelines. The preferred embodiment for maximizing the Quality (Q) factor of the inductor is to etch the isolation trench 30 as deep as is possible into the silicon substrate 12, for example in the range from 4 to 10 μm. Isolation trenches 30 are typically 6μm deep with respect to substrate 12 surface 14 and are typically 1μm wide and spaced apart with a 2.5μm center to center spacing. A shallow trench 15 is formed in upper surface 14 and filled with material after isolation trenches 30 are formed and filled with material.

Fig. 2 shows a enlarged view of a portion of isolation trench 30. Within isolation trench 30 is a layer or layers of semi-insulating or highly resistive material such as in the range from 2 to 500 (kohms). The material 35 which may be for example intrinsic poly-silicon may be filled either from the bottom of trench 30 up to the surface 14 of substrate 12 which may be for example be silicon, or by filling with a conformal deposition and removing the excess film from surface 14 of substrate 12 either by etchback or planarization methods. The preferred embodiment for this invention is to line trench 30 with a few thousand Angstroms of silicon oxide 32 such as by Low Pressure Chemical Vapor Deposition Tetraethyl Orthosilicate (LPCVD TEOS). Silicon oxide 32 may be highly conformal. Subsequent to the deposition or formation of silicon oxide 32 or some other insulator eg Silicon Nitride, trench 30 is overfilled with material 35 such as for example undoped LPCVD polysilicon. Material 35 and upper surface 14 is planarized by chemical-mechanical polishing (CMP).

Additional processing steps are performed to form shallow trench 15 which may be for example be 5500 Angstroms deep below upper surface 14. Shallow trench 15 may remove the upper portion of trench 30, and may be wider than all of the trenches and as long or longer than all of the trenches, to have a rectangular or square shape with respect to a top view. Preferably, the shallow trench is wider than three of the isolation trenches.

Additional processing steps may also be performed to form devices such as bipolar, n and p type FET's in substrate 12.

Above upper surface 14, three levels of metalization are shown comprising of metal layers 37, 38 and 39. Metal layers 37, 38 and 39 are formed on insulation layers 41, 42 and 43 respectively. Vias or studs are drilled in insulation layers 41, 42 and 43 respectively and filled with conductive material such as metal selected from the group consisting of tungsten, Al, AlCu, Al2Cu and Cu to provide electrical interconnection between devices in substrate 12 and metal layer 37 and between metal layers 37-39. Metal layers 37, 38, and 39 may be patterned or etched and then intralevel dielectric 46, 47 and 48, respectively may be deposited such as SiO2 or flowed on with a flowable oxide. Alternatively, metal layers 37, 38 and 39 may be blanket deposited in channels or grooves first formed in interlevel dielectric and then chemical-mechanical polished (CMP) to provide a coplanar surface with the intralevel dielectric which isolates the metal in the channels. If metal layer 39 is the last metal layer, then intralevel dielectric 48 may be omitted. As shown in Fig. 1, the metal layers and intralevel dielectric may be planarized by CMP. Insulation layers 41, 42 and 43 may be planarized by CMP also.

With metal layers 37-39, the on-chip inductors 20 are fabricated by litho-graphically patterned by subtractive etching of wiring metal layers or by patterned interlevel layers 41 to 43, dielectric filling with metal and damascene polishing by CMP. Inductors 20 which may be spiral inductors, can be formed either from a single or multiple levels of metal layers 37-39. In Fig. 1, two levels of metal, metal layers 38 and 39, are shunted together through interlevel vias 45 which is further described in US Patent 5446311 which issued Aug. 29, 1995 by M. Soyuer et al. which is incorporated herein by reference.

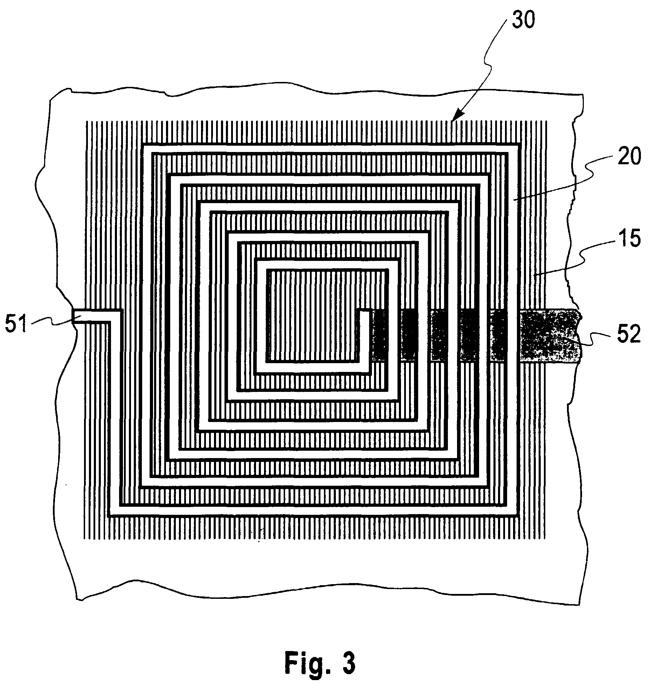

Fig. 3 is a top view of an on-chip inductor 20 such as shown in cross section in Fig. 1. Spiral inductor 20 is formed over shallow trench 15 which in turn is over a plurality of isolation trenches 30 which are parallel to one another. One end of inductor 20 is at terminal 51 and the other end is at terminal 52.

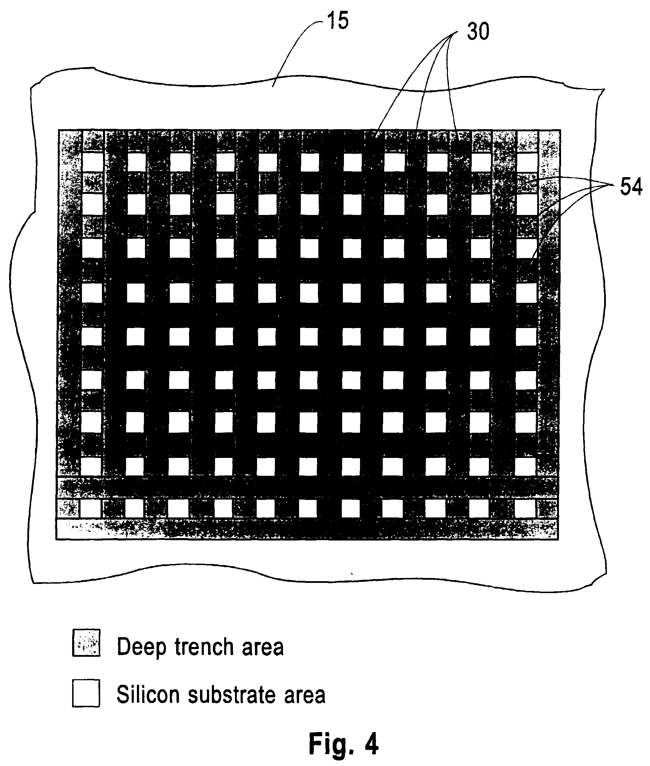

Fig. 4 is a top view of shallow trench 15 and cross hatched isolation trenches formed by parallel isolation trenches 30 and parallel isolation trenches 54 which are transverse to isolation trenches 30. Inductor 20 which is formed thereover is not shown in Fig. 4. The so-called "cross-hatch" layout has replaced the volume of silicon substrate material by a factor of greater than 3:1.

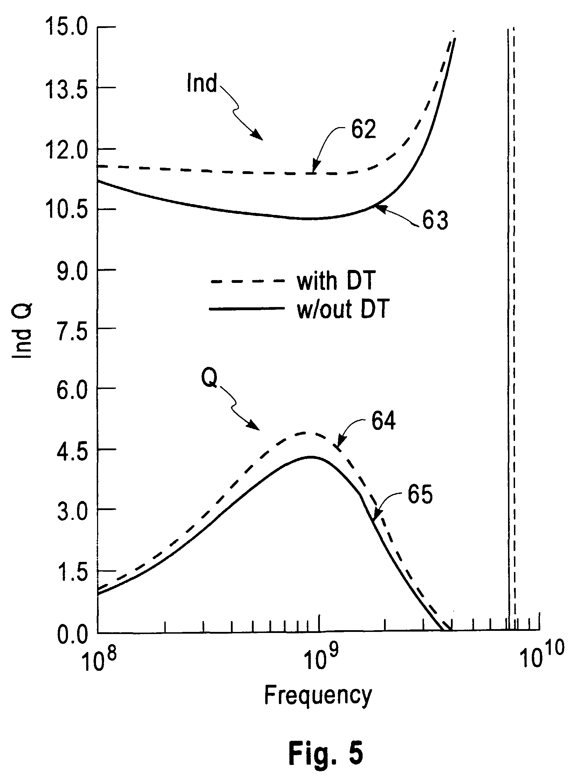

Fig. 5 is a graph showing the inductance of a spiral inductor versus frequency. The spiral inductor was constructed in accordance with Fig. 1. Curve 62 shows the inductance of a 6 turn spiral inductor with metal layers 38 and 39 tied together. The device with deep trenches 30 located directly underneath have a higher peak Q value as shown by curve 64. Curve 64 also shows a higher Q value for a given frequency.

Curve 63 shows the inductance as above except without deep trenches 30 underneath the 6 turn spiral inductor.

Curve 65 shows the Q as above except without deep trenches 30 underneath the 6 turn spiral inductor.

While there has been described and illustrated an integrated circuit containing a passive component such as an inductor over a high resistance area formed in a semiconductor substrate wherein the high resistance area or volume comprises a plurality of parallel or cross hatched isolation trenches, it will be apparent to those skilled in the art that modifications and variations are possible without deviating from the broad scope of the invention which shall be limited solely by the scope of the claims appended hereto.

**Claims**

1. An integrated circuit comprising:

   a semiconductor substrate (12),

   a plurality of spaced apart isolation trenches (30) substantially parallel to one another formed in said semiconductor substrate,

   said trenches filled with a material having a resistance greater than the resistance of said substrate and filled to the top surface of said trenches to provide a continuous surface across said plurality of trenches and the substrate therebetween,

   an insulator layer (41) formed above said plurality of spaced apart trenches, and

   a passive component (20) formed above said plurality of spaced apart trenches whereby said plurality of spaced apart trenches below said passive component form a high resistance region with respect to the resistance of said substrate.

2. The integrated circuit of Claim 1 wherein said isolation trenches further include an insulating layer formed on the sidewalls of said plurality of isolation trenches.

3. The integrated circuit of Claim 2 wherein said insulating layer is selected from the group consisting of silicon dioxide and silicon nitride.

4. The integrated circuit of any preceding claim wherein said isolation trenches are filled with a material selected from the group consisting of silicon dioxide, silicon nitride and polysilicon.

5. The integrated circuit of any preceding claim further including a shallow trench filled with a material selected from the group consisting of silicon dioxide, silicon nitride and polysilicon and formed in said substrate where said plurality of isolation trenches are located.

6. The integrated circuit of claim 5 wherein the shallow trench is wider than three of said isolation trenches.

7. The integrated circuit of any preceding claim further including a second plurality of spaced apart trenches substantially parallel to one another formed in said semiconductor substrate transverse to said first plurality of spaced apart trenches.

8. The integrated circuit of claim 7 wherein said second plurality of spaced apart trenches are formed in the same location of said first plurality of trenches to form a cross hatch pattern.

9. The integrated circuit of claim 8 wherein said first and second plurality of spaced apart trenches replace the volume of said substrate by a factor of 3 to 1 or greater.

10. A process for forming an integrated circuit comprising the steps of:

    forming a plurality of spaced apart trenches substantially parallel to one another in a semiconductor substrate,

    filling said trenches with a material having a resistance greater than the resistance of said substrate and filling said trenches to the top of said trenches to provide a continuous surface across said plurality of trenches,

    forming a insulation layer above said plurality of trenches, and forming a passive component above said insulation layer above said plurality of trenches.

10

39

45        45

48

43

15

38

20

42

47

37

46

41

14

15

12

30        30

35        35

32        32

35'   32

**Fig. 1**        **Fig. 2**

**Fig. 3**

**Fig. 4**

□ Deep trench area

□ Silicon substrate area

**Fig. 5**

**European Patent Office**

**EUROPEAN SEARCH REPORT**

Application Number

EP 98 30 4845

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | WO 97 45873 A (ERICSSON TELEFON AB L M) 4 December 1997 * the whole document * | 1-4,7-10 | H01L23/64 H01L21/762 H01L21/3205 |
| X | EP 0 346 625 A (TOKYO SHIBAURA ELECTRIC CO) 20 December 1989 * the whole document * | 1-4,7-10 | |
| | | | TECHNICAL FIELDS SEARCHED (Int.Cl.6) H01L |

The present search report has been drawn up for all claims

| Place of search | Date of completion of the search | Examiner |
|---|---|---|
| THE HAGUE | 5 November 1998 | Albrecht, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 98 30 4845

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-1998

| Patent document cited in search report | | Publication date | Patent family member(s) | | Publication date |
|---|---|---|---|---|---|
| WO 9745873 | A | 04-12-1997 | AU | 3113097 A | 05-01-1998 |
| | | | SE | 9602191 A | 01-12-1997 |
| EP 0346625 | A | 20-12-1989 | JP | 1289264 A | 21-11-1989 |
| | | | DE | 68927487 D | 09-01-1997 |
| | | | DE | 68927487 T | 24-04-1997 |

EPO FORM P0459

For more details about this annex : see Official Journal of the European Patent Office, No. 12/82